# EUROPEAN PATENT APPLICATION

(11) **EP 4 325 579 A1**
(43) Date of publication of application: **21.02.2024**
(21) Application number: 23801660.4
(22) Date of filing: 22.03.2023
(51) Int. Cl.: H01L 29/06, H01L 29/10, H01L 21/336, H01L 29/78

(54) **MOSFET DEVICE AND MANUFACTURING METHOD THEREFOR**

(30) Priority: 14.11.2022 CN 202211425863
(71) Applicant: Yuezhou Semiconductor Manufacturing Electronics (Shaoxing) Corp, Shaoxing, Zhejiang 312000 (CN)
(72) Inventor: LI, Xiang, Shaoxing, Zhejiang 312000 (CN); XIE, Zhiping, Shaoxing, Zhejiang 312000 (CN); CONG, Maojie, Shaoxing, Zhejiang 312000 (CN); LIANG, Xinying, Shaoxing, Zhejiang 312000 (CN); LUO, Ding, Shaoxing, Zhejiang 312000 (CN)
(74) Representative: Kraus & Lederer PartGmbB
(86) International application number: PCT/CN2023/082994
(87) International publication number: WO 2024/001327

(57) **Abstract**

The present invention provides a MOSFET device and a manufacturing method therefor. First, a patterned mask is utilized to implant first ions, to form a well region in which diffusion is not easy. Then, the patterned mask and spacers on its sidewalls are utilized to implant second ions in self-alignment with a source region. Further, the characteristic that the second ions are easier to diffuse than the first ions is utilized to form a semi-superjunction located at a bottom of the well region and connected to the bottom of the well region. The semi-superjunction can effectively expand a junction depth of the well region, so that a withstand voltage of the device can be increased to achieve high-conduction performance of the device, and can also shift a peak of electric field strength below a gate oxide layer to below the well region, so that the electric field strength below the gate oxide layer is effectively reduced and is more uniform, thereby improving the reliability of the device.

## Description

### TECHNICAL FIELD

The present invention relates to the field of MOSFET device manufacturing technologies, and in particular, to a MOSFET device and a manufacturing method therefor.

### BACKGROUND

A silicon carbide (SiC) metal oxide semiconductor field effect transistor (MOSFET) device has advantages such as a high switching speed and low on-resistance, and can achieve a higher breakdown voltage level with a smaller drift layer thickness, thereby reducing a volume of a power switch module and reducing energy consumption. The MOSFET device has obvious advantages in application fields such as power switches and converters.

Due to weak diffusion of aluminum (Al) ions implanted in SiC, in an existing process of a planar gate SiC MOSFET, generally, a P well with a specific depth is first obtained through a method of implanting Al ions a plurality of times. Because the poor diffusion effect of Al ions in SiC, a deeper junction depth cannot be obtained through a diffusion process, and a withstand voltage of SiC of the MOSFET cannot reach an ideal value. Moreover, there is always a peak electric field below a gate oxide layer, the reliability of the SiC MOSFET device is always challenged.

The foregoing problem also exist in other planar MOSFET processes in which a P well is formed by implanting Al ions a plurality of times.

### SUMMARY

An objective of the present invention is to provide a MOSFET device and a manufacturing method therefor, to lower an electric field peak at a bottom of a gate oxide layer, increase a withstand voltage of the device, and improve the reliability of the device.

To achieve the foregoing objective, the present invention provides a manufacturing method for a MOSFET device, including following steps:
providing a substrate, forming a patterned mask layer on the substrate, and implanting first ions of a first conductivity type into a surface layer of the substrate by using the patterned mask layer as a mask, to form a well region;
forming spacers on both sidewalls of the patterned mask layer, and implanting ions of a second conductivity type into a surface layer of the well region by using the patterned mask layer and the spacers as a mask, to form a source region;
implanting second ions of the first conductivity type into the substrate below the well region by using the patterned mask layer and the spacers as a mask, where the second ions are easier to diffuse in the substrate than the first ions, to form a semi-superjunction connected to a bottom of the well region and self-aligned with the source region; and
forming, on the substrate, a gate oxide layer and a gate that are sequentially stacked, where a region in which the well region overlaps the gate is used as a channel of the MOSFET device.

Optionally, the provided substrate includes a base of the second conductivity type, a buffer layer of the second conductivity type, and a drift layer of the second conductivity type, where the drift layer is a silicon carbide layer, and the well region and the semi-superjunction are both formed in the drift layer.

Optionally, after the second ions of the first conductivity type are implanted into the substrate below the well region, annealing activation is performed, and during the annealing activation, the second ions are easier to diffuse in the substrate than the first ions, and then, the second ions form the semi-superjunction after being diffused in the substrate.

Optionally, after the second ions are implanted, and before the annealing activation is performed to form the semi-superjunction, the manufacturing method further includes:
removing the patterned mask layer and the spacers; and
forming a body contact region of the first conductivity type and a junction implantation region of the second conductivity type through implantation of corresponding ions, where the body contact region is formed in the source region and extends into a part of the well region to short-circuit the source region and the well region, and the junction implantation region is located at a bottom of the gate and between parts of the well region on both sides of the gate.

Optionally, the first ions include aluminum ions, and the second ions include boron ions and/or boron fluoride ions.

Optionally, implantation process parameters of the first ions include implantation energy ranging from 50 keV to 800 keV and an implantation dose ranging from 1E12/cm² to 9E13/cm²; and/or implantation process parameters of the second ions include implantation energy ranging from 100 keV to 2 MeV and an implantation dose ranging from 1E12/cm² to 5E14/cm².

Optionally, process conditions of the annealing activation include an annealing temperature ranging 1500°C to 1900°C and an annealing time ranging from 2 min to 200 min.

Optionally, the manufacturing method further includes:
forming an interlayer dielectric layer on the substrate, where the interlayer dielectric layer buries the gate and exposes a part of the source region;
forming a source metal layer on the interlayer dielectric layer, where the source metal layer is electrically connected to the source region; and
forming a drain metal layer on a bottom surface of the substrate.

Based on a same invention concept, the present invention further provides a MOSFET device, including:
a substrate, where a well region and a semi-superjunction that are of a first conductivity type and a source region of a second conductivity type are formed in the substrate, the well region is formed in a surface layer of a partial region of the substrate, the source region is formed in a surface layer of the well region, and the semi-superjunction is formed in the substrate below the well region, is self-aligned with the source region, and is connected to a bottom of the well region; and
a gate oxide layer and a gate, sequentially stacked on the substrate, where the gate overlaps the source region, and the well region on a side of the source region and located at a bottom of the gate forms a channel of the MOSFET device.

Optionally, the MOSFET device includes a base of the second conductivity type, a buffer layer of the second conductivity type, and a drift layer of the second conductivity type, where the drift layer is a silicon carbide layer, and the well region and the semi-superjunction are both formed in the drift layer; and ions of the first conductivity type doped in the well region include aluminum ions, and ions of the first conductivity type doped in the semi-superjunction include boron ions and/or boron fluoride ions.

Compared with the prior art, the technical solutions of the present invention have at least the following beneficial effects:
1. First, a patterned mask is utilized to implant first ions, to form a well region in which diffusion is not easy. Then, the patterned mask and spacers on its sidewalls are utilized to implant second ions in self-alignment with a source region. Further, the characteristic that the second ions are easier to diffuse than the first ions is utilized to form a semi-superjunction located at a bottom of the well region and connected to the bottom of the well region. The semi-superjunction can effectively expand a junction depth of the well region, so that a withstand voltage of the device can be increased to achieve high-conduction performance of the device, and can also shift a peak of electric field strength below a gate oxide layer to below the well region, so that the electric field strength below the gate oxide layer is effectively reduced and is more uniform, thereby improving the reliability of the device.
2. The process is easy to implement, and the required structure can be achieved without multi-layer photolithography.

### BRIEF DESCRIPTION OF THE DRAWINGS

It will be understood by a person of ordinary skill in the art that the accompanying drawings are provided for better understanding of the present invention and do not constitute any limitation to the scope of the present invention.
FIG. 1 is a schematic flowchart of a manufacturing method for a MOSFET device according to an embodiment of the present invention;
FIG. 2 is a schematic cross-sectional diagram of a device structure in the manufacturing method for a MOSFET device shown in FIG. 1;
FIG. 3 is a schematic diagram of comparison between a distribution region with higher electric field strength in a MOSFET device in the prior art and a distribution region with higher electric field strength in a MOSFET device of the present invention; and
FIG. 4 is a schematic diagram of comparison between a curve of electric field distribution in a MOSFET device in the prior art and a curve of electric field distribution in a MOSFET device of the present invention.

### DETAILED DESCRIPTION

In the following description, numerous specific details are given to facilitate a more thorough understanding of the present invention. However, it is obvious to a person skilled in the art that the present invention can be implemented without one or more of these details. In other examples, to avoid confusion with the present invention, some technical features known in the art are not described It should be understood that the present invention can be implemented in different forms and should not be construed as being limited to the embodiments presented herein. Conversely, these embodiments are provided for the purpose of making the disclosure thorough and complete, and conveying the scope of the present invention fully to a person skilled in the art. In the drawings, for the sake of clarity, the sizes and relative sizes of layers and regions may be exaggerated, and the same reference numerals denote the same elements throughout the present invention. It should be understood that when an element or layer is referred to as being "on" or "connected to" other elements or layers, it can be directly located on or connected to the other elements or layers, or there may be an intervening element or layer. Conversely, when an element is referred to as being "directly on" or "directly connected to" other elements or layers, no intervening element or layer is present. Although the terms, such as first and second, can be used to describe various elements, components, regions, layers and/or portions, these elements, components, regions, layers and/or portions should not be limited by these terms. These terms are only used to distinguish one element, component, region, layer or portion from another element, component, region, layer or portion. Therefore, without departing from the teachings of the present invention, the first element, component, region, layer or portion discussed below may be expressed as a second element, component, region, layer or portion. Terms indicating the spatial relationships, such as "under", "below", "lower", "above", and "upper", are used herein for the convenience of description, to describe the relationship between one element or feature and other elements or features shown in the figure. It can be understood that in addition to the orientations shown in the figures, the terms indicating the spatial relationships are also intended to include different orientations of a device in use and operation. For example, if the device in the figure is upside down, then an element or feature described as being "under", "below", or "lower" will be oriented to be "above" other elements or features. The device can be otherwise oriented (rotated by 90 degrees or in other orientations) and the spatial descriptions used here are interpreted accordingly. The terms are used herein merely for purpose of describing specific embodiments and not as a limitation of the present invention. When used herein, the singular forms "a", "an", and "the" are also meant to include the plural form, unless otherwise clearly indicated. It should also be understood that the term "include" is used to confirm the existence of the features, steps, operations, elements, and/or components, but do not exclude the existence or addition of one or more other features, steps, operations, elements, components, and/or groups. As used herein, the term "and/or" includes any and all combinations of related listed items.

The technical solutions provided in the present invention are further described below in detail with reference to the accompanying drawings and specific embodiments. The advantages and features of the present invention are more clearly according to the following descriptions. It should be noted that the accompanying drawings are all in a very simplified form and are not drawn to accurate scale, but are merely used for convenience and clarity of description of the embodiments of the present invention.

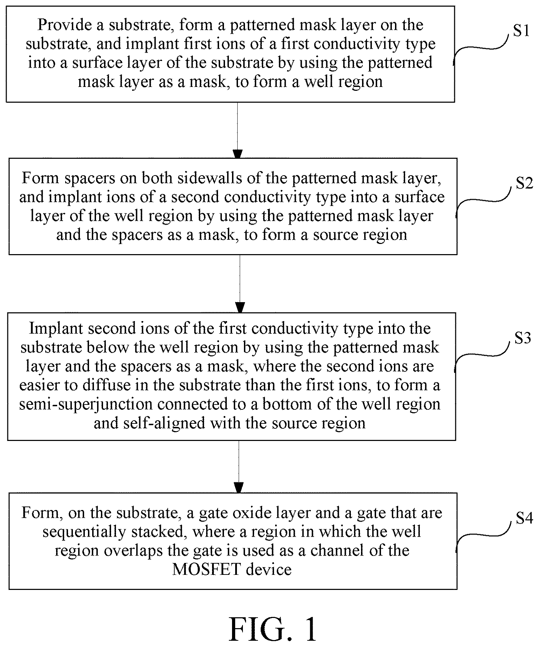

Referring to FIG. 1, an embodiment of the present invention provides a manufacturing method for a MOSFET device, including following steps:
S1: Provide a substrate, form a patterned mask layer on the substrate, and implant first ions of a first conductivity type into a surface layer of the substrate by using the patterned mask layer as a mask, to form a well region.
S2: Form spacers on both sidewalls of the patterned mask layer, and implant ions of a second conductivity type into a surface layer of the well region by using the patterned mask layer and the spacers as a mask, to form a source region.
S3: Implant second ions of the first conductivity type into the substrate below the well region by using the patterned mask layer and the spacers as a mask, where the second ions are easier to diffuse in the substrate than the first ions, to form a semi-superjunction connected to a bottom of the well region and self-aligned with the source region.
S4: Form, on the substrate, a gate oxide layer and a gate that are sequentially stacked, where a region in which the well region overlaps the gate is used as a channel of the MOSFET device.

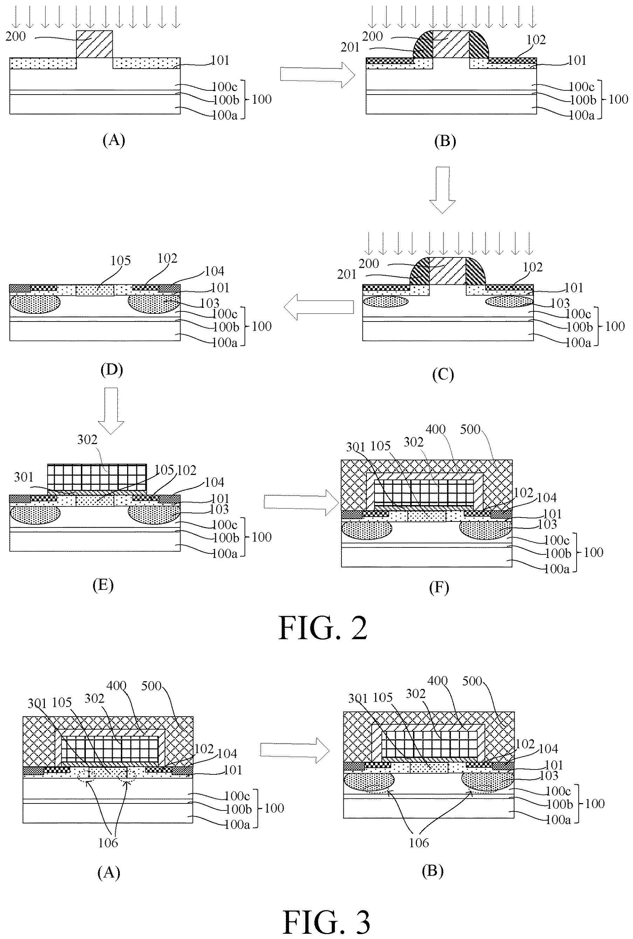

With reference to FIG. 2, the technical solution of this embodiment is described in detail by using an example in which the first conductivity type is a P type, and the second conductivity type is an N type. Certainly, in another embodiment of the present invention, the first conductivity type may be an N type, and the second conductivity type may be a P type.

Specifically, referring to (A) in FIG. 2, in step S1, any suitable semiconductor material, such as silicon carbide (SiC) and silicon, may be provided to form a substrate 100. For example, the provided substrate 100 is an N-type substrate, and includes an N+ base 100a, an N buffer layer 100b, and an N- drift layer 100c that are sequentially stacked from bottom to top. In the N+ base 100a, the N buffer layer 100b, and the N- drift layer 100c, at least the N- drift layer 100c is a SiC layer. In addition, a doping concentration of N-type ions in the N- drift layer 100c is lower than a doping concentration of N-type ions in the N+ base 100a.

Referring to (A) in FIG. 2, in step S1, first, a surface of the substrate 100 may be cleaned and dried. Then, a mask layer material is deposited on the N- drift layer 100c. The mask layer material may be selected from, for example, one or more of polycrystalline silicon (poly Si), monocrystalline silicon (Si), silicon dioxide (SiO₂), silicon nitride (SiN), and the like, and may be a single layer of film or a stack of films of a plurality of different materials. A patterned mask layer 200 for defining a to-be-formed P well is formed by performing photolithography and etching on the mask layer material. In this example, to-be-formed P well implantation windows (not shown) are defined on both sides of the patterned mask layer 200. It can be learned that parameters, such as a shape and a line width, of the patterned mask layer 200 all need to be designed according to a to-be-formed well region 101, and are not specifically limited in the present invention.

Still referring to (A) in FIG. 2, in step S1, subsequently, P-type first ions are implanted into a surface layer of the N- drift layer 100c by using the patterned mask layer 200 as a mask, to form the well region 101 in the surface layer of the N- drift layer 100c on the both sides of the patterned mask layer 200. The first ions selected in this step are ions that can form holes in the N- drift layer 100c and are less likely to diffuse at a high temperature than subsequent second ions and source ions.

In an example, the first ions include element ions, such as aluminum (Al) ions, that are non-diffusible in SiC. An implantation direction of the first ions may be perpendicular to a surface of the N- drift layer 100c or may be at a specific tilt angle to the surface of the N- drift layer 100c. An implantation temperature of the first ions ranges from 400°C to 1000°C (for example, 500°C or 800°C). Implantation energy of the first ions ranges from 50 keV to 800 keV (for example, 100 keV, 200 keV, 400 keV, 500 keV, 600 keV, or 700 keV). An implantation dose of the first ions ranges from 1E12/cm² to 9E13/cm² (for example, 5E12/cm² or 1E13/cm²).

Referring to (B) in FIG. 2, in step S2, first, through a process such as deposition or coating, the surface of the N- drift layer 100c and a surface of the patterned mask layer 200 are covered with a spacer material (not shown) the same as or different from the material of the patterned mask layer 200, and further, through a spacer self-alignment process requiring no photomask (for example, a wet etching process or an anisotropy dry etching process), excess spacer material is removed to form spacers 201 covering sidewalls of the patterned mask layer 200. In an example, when the patterned mask layer 200 is SiN, the spacers 201 may be SiN, silica, poly Si, or the like. Parameters, such as shapes and line widths, of the spacers all need to be designed according to requirements of a to-be-formed source region 102, and are not specifically limited in the present invention.

Still referring to (B) in FIG. 2, in step S2, subsequently, N-type ions are implanted perpendicularly or obliquely into a surface layer of the well region 101 by using the patterned mask layer 200 and the spacers 201 as a mask, to form the source region 102 in the surface layer of the well region 101 on the both sides of the patterned mask layer 200. In an example, the N-type ions include at least one of phosphorus (P) ions, arsenic (As) ions, nitrogen (N) ions, and the like, implantation energy of the N-type ions ranges from 50 keV to 400 keV (for example, 100 keV or 200 keV), and an implantation dose of the N-type ions ranges from 1E14/cm² to 1E16/cm² (for example, 5E14/cm², 1E15/cm², or 5E15/cm²).

Still referring to (C) in FIG. 2, in step S3, P-type second ions are implanted into the N-drift layer 100c below the well region 101 by using the patterned mask layer 200 and the spacers 201 as a mask, to form a semi-superjunction 103 self-aligned with the source region 102 in the N- drift layer 100c below the well region 101 on the both sides of the patterned mask layer 200. In this way, the semi-superjunction 103 can form a junction deeper than the well region 101. P-type ions that are easier to diffuse in the N- drift layer 100c are selected as the second ions. For example, the second ions include boron ions, boron fluoride ions, or a combination of the two. An implantation direction of the second ions may be perpendicular to the surface of the N- drift layer 100c. Implantation energy of the second ions ranges from 100 keV to 2 MeV (for example, 500 keV, 800 keV, or 1 MeV). An implantation dose of the second ions ranges from 1E12/cm² to 5E14/cm² (for example, 5E12/cm², 1E13/cm², 5E13/cm², or 1E14/cm²).

It should be noted that a junction depth of the semi-superjunction 103 does not reach a bottom surface of the N- drift layer 100c. Therefore, the junction depth is shallower than that of a conventional superjunction. In this embodiment, a depth-to-width ratio of the semi-superjunction 103 may be less than or equal to 5. In an example, the junction depth of the semi-superjunction 103 (that is, a distance of the semi-superjunction 103 from a top surface of the N- drift layer 100c) ranges from 1 µm to 5 µm.

Referring to (D) in FIG. 2, in step S3, optionally, after the P-type second ions are implanted, the patterned mask layer 200 and the spacers 201 may be removed first. Moreover, P-type ions including at least one of boron ions, boron fluoride ions, and aluminum ions are further implanted into a part of the source region 102, to form a body contact region 104. In addition, N-type ions, such as nitrogen ions, are implanted into the surface layer of the N- drift layer 100c between parts of the well region 101 on both sides, to form a junction implantation region 105. A bottom of the body contact region 104 extends into a part of the well region 101, to short-circuit the source region 102 and the well region 101, and a doping concentration of P-type ions of the body contact region 104 is higher than that of the well region 101. In an example, conditions of an ion implantation process for forming the body contact region 104 include implantation energy ranging from 50 keV to 300 keV (for example, 100 keV or 200 keV) and an implantation dose ranging from 1E13/cm² to 1E16/cm² (for example, 5E14/cm², 1E15/cm², or 5E15/cm²).

Still referring to (D) in FIG. 2, in step S3, after corresponding ion implantation processes are completed, the substrate 100 is annealed through an annealing activation process, to activate all the implanted ions. An annealing temperature ranges from 1500°C to 1900°C (for example, 1650°C, 1700°C, or 1800°C). An annealing time ranges from 2 min to 200 min (for example, 10 min, 20 min, 50 min, or 100 min). In the annealing activation process, the second ions in the semi-superjunction 103 are easier to diffuse than the first ions in the well region 101. Longitudinally, a top of the diffused semi-superjunction 103 is connected to the bottom of the well region 101, and a bottom thereof is diffused to a required depth in the N- drift layer 100c, and laterally, the diffused semi-superjunction 103 is expanded to a junction width required by the device.

Referring to (E) in FIG. 2, in step S4, first, a gate oxide layer 301 may be formed on surfaces of the body contact region 104, the source region 102, the well region 101, and the junction implantation region (a JFET region) 105 through a suitable gate oxide process such as a thermal oxidation process or chemical vapor deposition. Then, a gate material layer (for example, doped poly Si) may be deposited on a surface of the gate oxide layer 301, and a gate 302 is formed by performing photolithography and etching on the deposited gate material layer and the gate oxide layer 301. The formed gate 302 overlaps both the well region 101 and the source region 102, and an overlapping region between the well region 101 and the gate 302 is used as a channel (the channel extends from a boundary of the source region 102 to a boundary of the junction implantation region 105) of the MOSFET device.

Further, optionally, referring to (F) in FIG. 2, after the gate 302 is formed, first, an interlayer dielectric layer 400 is covered on the substrate 100 and the gate 302 through a chemical vapor deposition process and the like. The interlayer dielectric layer 400 may be a single-layer dielectric film structure or a structure formed by stacking a plurality of dielectric films. Then, the interlayer dielectric layer 400 is patterned by performing photolithography and etching on the interlayer dielectric layer 400. The patterned interlayer dielectric layer 400 may bury the gate 302 and expose a part of the source region 102. Then, a source metal layer 500 (for example, a metal material, such as copper, aluminum, or gold, or an alloy) is formed on the interlayer dielectric layer 400 through a suitable process such as metal sputtering deposition or evaporation. The source metal layer 500 is electrically connected to both the source region 102 and the body contact region 104. Subsequently, a drain metal layer (not shown) is formed on a back surface of the N+ base 100a.

Referring to (F) in FIG. 2, an embodiment of the present invention further provides a MOSFET device, which is preferably manufactured by using the manufacturing method for a MOSFET device according to the present invention. The MOSFET device includes a substrate 100, a gate oxide layer 301, a gate 302, an interlayer dielectric layer 400, and a source metal layer 500.

The substrate 100 may be of any suitable semiconductor material. For example, the substrate 100 is an N-type SiC substrate, and includes three layers from bottom to top, which are sequentially an N+ base 100a, an N buffer layer 100b, and an N- drift layer 100c. A P-type well region 101, an N-type source region 102, a P-type semi-superjunction 103, a P-type body contact region 104, and an N-type junction implantation region 105 are formed in the N- drift layer 100c. The well region 101 is formed in a surface layer of a partial region of the N- drift layer 100c. The source region 102 is formed in a surface layer of the well region 101. The semi-superjunction 103 is formed in the N- drift layer 100c below a bottom of the well region 101, is self-aligned with the source region 102, and is connected to the bottom of the well region 101. P-type ions doped in the well region 101 include ions, such as aluminum ions, that are not easy to diffuse, and P-type ions doped in the semi-superjunction 103 include ions, such as boron ions and/or boron fluoride ions, that are easy to diffuse. The body contact region 104 is formed in the source region 102 and short-circuits the source region 102 and the well region 101. The junction implantation region 105 is formed in the N- drift layer 100c between parts of the well region 101 on both sides of a bottom of the gate 302.

The gate oxide layer 301 and the gate 302 are sequentially stacked on the N- drift layer 100c, and the gate 302 overlaps both the well region 101 and the source region 102. An overlapping region between the well region 101 and the gate 302 is a channel of the MOSFET device.

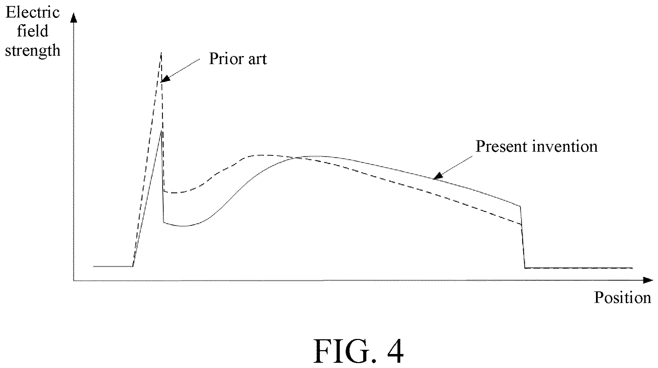

To better describe the effects of the MOSFET device manufactured according to this embodiment, in this embodiment, simulation tests are performed on the MOSFET device according to this embodiment and a MOSFET device in the prior art. The MOSFET device in the prior art differs from the MOSFET device according to this embodiment in that a drift layer below a bottom of a well region of the MOSFET device in the prior art does not include a semi-superjunction structure, and the remaining structures, manufacturing steps, and process conditions, and the like are the same as those of the MOSFET device according to this embodiment. It is found through the tests that there is a peak electric field 106 below a gate oxide layer 301 of the MOSFET device in the prior art, and the peak electric field 106 (that is, a peak of electric field strength, an electric field peak for short) is close to the gate oxide layer 301, as shown in FIG. 3A and FIG. 4. As a result, the reliability of the device is always challenged. An electric field peak near the gate oxide layer 301 of the MOSFET device according to this embodiment is reduced by 40% compared with the prior art, which is obviously effectively reduced. Moreover, the peak electric field 106 (that is, the electric field peak) is shifted to below the well region 101, specifically, to a bottom boundary region of the semi-superjunction 103, as shown in FIG. 3B and FIG. 4. The withstand voltage of the device is increased, and the reliability of the device is improved.

Therefore, it also shows that the semi-superjunction formed in the MOSFET device according to this embodiment can effectively expand a junction depth of the well region, so that a withstand voltage of the device can be increased to achieve high-conduction performance of the device, and can also shift a peak of electric field strength below a gate oxide layer to below the well region, so that the electric field strength below the gate oxide layer is effectively reduced and is more uniform, thereby improving the reliability of the device.

In conclusion, in the manufacturing method for a MOSFET device according to the present invention, first, a patterned mask is utilized to implant first ions, to form a well region in which diffusion is not easy. Then, the patterned mask and spacers on its sidewalls are utilized to implant second ions in self-alignment with a source region. Further, the characteristic that the second ions are easier to diffuse than the first ions is utilized to form a semi-superjunction located at a bottom of the well region and connected to the bottom of the well region. The semi-superjunction can effectively expand a junction depth of the well region, so that a withstand voltage of the device can be increased to achieve high-conduction performance of the device, and can also shift a peak of electric field strength below a gate oxide layer to below the well region, so that the electric field strength below the gate oxide layer is effectively reduced and is more uniform, thereby improving the reliability of the device. In addition, in the manufacturing method for a MOSFET device according to the present invention, ion implantation windows of the source region and the semi-superjunction are implemented through the spacers formed in a self-aligned manner on the sidewalls of the patterned mask layer for defining an ion implantation window of the well region. The process is easy to implement, requires no additional multi-layer photolithography, and has low costs.

In addition, because the MOSFET device according to the present invention includes a semi-superjunction structure at the bottom of the well region, the electric field strength below the gate oxide layer is effectively reduced and is more uniform. In addition, the withstand voltage of the device is increased, and the reliability of the device is improved.

The foregoing descriptions are merely descriptions of the preferred embodiments of the present invention and do not limit the scope of the present invention in any way. All changes or modifications made by a person of ordinary skill in the art of the present invention according to the foregoing disclosure fall within the protection scope of the technical solutions of the present invention.

## Claims

1. A manufacturing method for a metal oxide semiconductor field effect transistor (MOSFET) device, comprising:
providing a substrate, forming a patterned mask layer on the substrate, and implanting first ions of a first conductivity type into a surface layer of the substrate by using the patterned mask layer as a mask, to form a well region;
forming spacers on both sidewalls of the patterned mask layer, and implanting ions of a second conductivity type into a surface layer of the well region by using the patterned mask layer and the spacers as a mask, to form a source region;
implanting second ions of the first conductivity type into the substrate below the well region by using the patterned mask layer and the spacers as a mask, wherein the second ions are easier to diffuse in the substrate than the first ions, to form a semi-superjunction connected to a bottom of the well region and self-aligned with the source region; and
forming, on the substrate, a gate oxide layer and a gate that are sequentially stacked, wherein a region in which the well region overlaps the gate is used as a channel of the MOSFET device.

2. The manufacturing method according to claim 1, wherein the provided substrate comprises a base of the second conductivity type, a buffer layer of the second conductivity type, and a drift layer of the second conductivity type, wherein the drift layer is a silicon carbide layer, and the well region and the semi-superjunction are both formed in the drift layer.

3. The manufacturing method according to claim 1, wherein after the second ions of the first conductivity type are implanted into the substrate below the well region, annealing activation is performed, and during the annealing activation, the second ions are easier to diffuse in the substrate than the first ions, and then, the second ions form the semi-superjunction after being diffused in the substrate.

4. The manufacturing method according to claim 3, wherein after the second ions are implanted, and before the annealing activation is performed to form the semi-superjunction, the manufacturing method further comprises:
removing the patterned mask layer and the spacers; and
forming a body contact region of the first conductivity type and a junction implantation region of the second conductivity type through implantation of corresponding ions, wherein the body contact region is formed in the source region and extends into a part of the well region to short-circuit the source region and the well region, and the junction implantation region is located at a bottom of the gate and between parts of the well region on both sides of the gate.

5. The manufacturing method according to claim 3, wherein the first ions comprise aluminum ions, and the second ions comprise boron ions and/or boron fluoride ions.

6. The manufacturing method according to claim 5, wherein implantation process parameters of the first ions comprise implantation energy ranging from 50 keV to 800 keV and an implantation dose ranging from 1E12/cm² to 9E13/cm²; and/or implantation process parameters of the second ions comprise implantation energy ranging from 100 keV to 2 MeV and an implantation dose ranging from 1E12/cm² to 5E14/cm².

7. The manufacturing method according to claim 5, wherein process conditions of the annealing activation comprise an annealing temperature ranging 1500°C to 1900°C and an annealing time ranging from 2 min to 200 min.

8. The manufacturing method according to any one of claims 1 to 7, further comprising:
forming an interlayer dielectric layer on the substrate, wherein the interlayer dielectric layer buries the gate and exposes a part of the source region;
forming a source metal layer on the interlayer dielectric layer, wherein the source metal layer is electrically connected to the source region; and
forming a drain metal layer on a bottom surface of the substrate.

9. A metal oxide semiconductor field effect transistor (MOSFET) device, comprising:
a substrate, wherein a well region and a semi-superjunction that are of a first conductivity type and a source region of a second conductivity type are formed in the substrate, the well region is formed in a surface layer of a partial region of the substrate, the source region is formed in a surface layer of the well region, and the semi-superjunction is formed in the substrate below the well region, is self-aligned with the source region, and is connected to a bottom of the well region; and
a gate oxide layer and a gate, sequentially stacked on the substrate, wherein the gate overlaps the source region, and the well region on a side of the source region and located at a bottom of the gate forms a channel of the MOSFET device.

10. The MOSFET device according to claim 9, comprising a base of the second conductivity type, a buffer layer of the second conductivity type, and a drift layer of the second conductivity type, wherein the drift layer is a silicon carbide layer, and the well region and the semi-superjunction are both formed in the drift layer; and ions of the first conductivity type doped in the well region comprise aluminum ions, and ions of the first conductivity type doped in the semi-superjunction comprise boron ions and/or boron fluoride ions.
